# EUROPEAN PATENT SPECIFICATION

(11) **EP 4 186 245 B1**
(45) Date of publication and mention of the grant of the patent: **04.11.2026**
(21) Application number: 21867967.8
(22) Date of filing: 21.09.2021
(51) Int. Cl.: H04R 19/01, H04R 3/06, H03F 1/08, H04R 1/08, H03F 3/16, H03F 3/185, H03F 3/345

(54) **ELECTRET CAPSULE**
ELEKTRETKAPSEL
CAPSULE ÉLECTRET

(30) Priority: 21.09.2020 AU 2020903377
(43) Date of publication of application: 31.05.2023
(73) Proprietor: Freedman Electronics Pty Limited, Silverwater, NSW 2128 (AU)
(72) Inventor: FREEDMAN, Peter, Silverwater, New South Wales 2128 (AU); SCHILLEBEECKX, Pieter, Silverwater, New South Wales 2128 (AU)
(74) Representative: Metroconsult Srl
(86) International application number: PCT/AU2021/051101
(87) International publication number: WO 2022/056610

(56) References cited:
- JP-A- 2006 245 740
- US-A- 4 764 690
- US-A1- 2005 002 538
- US-A1- 2007 104 339
- US-A1- 2013 058 506
- US-A1- 2018 234 764
- US-B2- 7 223 136
- US-B2- 7 907 743

## Description

### FIELD OF THE INVENTION

The present invention relates generally to the field of electret capsules, and more particularly to a circuit configuration of an impedance converter integrated in an electret capsule such as for use in pre-polarised condenser microphones.

### BACKGROUND

Electret capsules are commonly used within microphone designs and are readily available. However, with the development of micro-electromechanical systems (MEMS) capsules, electret capsules have started to fall out of favor - MEMS capsules are cheaper to produce, and so have replaced electret capsules in a majority of their applications. MEMS capsules, however, suffer from greater noise and are not readily available with directional polar response. Although the effect is insufficient to be a problem for consumer electronics, the signal output quality of high-end microphones such as those used by professionals suffer noticeably

With the growing popularity of MEMS capsules the supply of electronic components to create low-noise high performance electret capsules has rapidly decreased.

Therefore, there is a need for an alternative approach to electret capsule circuitry that is suitable for use in high-end microphones and provide either equivalent or improved functionality over traditional prior art electret capsules. The present invention satisfies this need.

Some prior art teaching relevant to the present invention may be found in: US 2007/104339 A1, US 7 907 743 B2, US 7 223 136 B2, US 4 764 690 A, US 2005/002538 A1, JP 2006 245740 A, US 2013/058506 A1 and US 2018/234764 A1.

### SUMMARY

The present invention is directed to an electret capsule circuit defined according to claim 1. Further aspects of the invention are defined according to the dependent claims.

The present invention relates generally to the field of electret capsules, and more particularly to a circuit configuration of an impedance converter integrated in an electret capsule such as for use in pre-polarised condenser microphones.

As detailed below, an electrical circuit of the electret capsule comprises two field-effect transistors (FETs), diodes (such as a zener diode), resistors, capacitors, and inductors.

In one aspect the present invention provides an electret capsule for use in a microphone, comprising two transistors (FETs), biasing diodes, and biasing resistors arranged within an electrical circuit.

In another aspect, the positioning of the biasing diodes and biasing resistors within the electrical circuit may be configured to provide a combined "hybrid bias" upon the FET. Whereas diode biasing provides excellent noise reduction and signal gain but lacks in temperature stability, and resistor biasing provides temperature stability but does not provide any improvement on noise reduction, it is considered that a hybrid biasing configuration provides a synergistic combination of the two prior art biasing forms.

In yet another aspect, the electret capsule may further comprise a "capsule FET" within the electrical circuit, the positioning of which may be configured to bias the FET. In one embodiment, the capsule FET may be in addition to the biasing resistor. In an alternate embodiment, the capsule FET may replace the biasing resistor in the electrical circuit.

In a further aspect, the electret capsule may comprise an inductor within the electrical circuit with one or more capacitors in series. The arrangement of the inductor and capacitors may facilitate improved noise rejection of the circuit with regards to an output signal.

### BRIEF DESCRIPTION OF THE DRAWINGS

Embodiments are illustrated by way of example and not limitation in the figures in the accompanying drawings, in which like references indicate similar elements and in which:
FIG. 1A illustrates an exploded view of an exemplary microphone assembly including an electret capsule;
FIG. 1B illustrates an exemplary connection of the electret capsule of FIG. 1A;
FIG. 2A illustrates a perspective view of an exemplary electret capsule coupled with an exemplary printed circuit board (PCB);
FIG. 2B illustrates a perspective view of the electret capsule decoupled from the PCB of FIG. 2A;
FIG. 2C illustrates a side view of the electret capsule of FIG. 2A;
FIG. 2D illustrates a bottom view of the electret capsule of FIG. 2A;
FIG. 2E illustrates a top view of the electret capsule and PCB of FIG. 2A;
FIG. 3 illustrates an exploded view of an exemplary electret capsule;
FIG. 4 illustrates an exemplary electret capsule circuit configuration; and
FIG. 5 illustrates another exemplary electret capsule circuit configuration.

### DETAILED DESCRIPTION OF THE INVENTION

The present invention relates generally to the field of electret capsules, and more particularly to a circuit configuration of an impedance converter integrated in an electret capsule such as for use in pre-polarised condenser microphones. The electret capsule of a microphone includes a gate biasing field effect transistor (FET) to facilitate biasing of a low noise FET. Advantageously, the use of a low noise FET in the electret capsule of a microphone provides for improved temperature stability, while achieving lower self-noise.

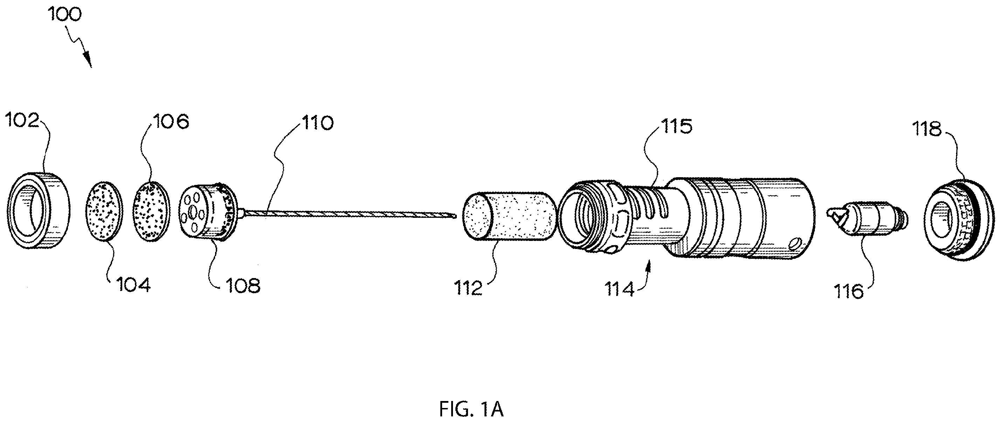

Turning now to the drawings wherein like numerals represent like components, FIG. 1A illustrates an exemplary microphone assembly 100. As shown, microphone assembly 100 may include a front cap 102, a coarse mesh 104, a fine mesh 106, an electret condenser capsule 108, a wire assembly 110, a protection mesh 112, a body 114, an audio connector 116, and a rear cap 118. It is contemplated that any type of microphone or microphone element may be used, such as for example, uni-directional or omni-directional microphones.

As illustrated, components of microphone 100 may be housed between front cap 102 and rear cap 118 within body 114. While body 114 is shown to be substantially tubular, other shapes are contemplated. As shown, body 114 may include one or more openings 115 to permit sound waves to enter. Body 114 and front/rear caps 102, 118 may be made of the same materials or different materials, such as metal, plastic or the like.

As mentioned above, microphone 100 may include one or more layers of mesh 104, 106, 112. The one or more mesh layers may be used to adjust the acoustic impedance properties of microphone 100 and may prevent intrusion of foreign matter and fine particles. Examples of mesh materials that may be used include nonmetallic (e.g., nonconductive) materials such as woven polyester and PVC-on-polyester fabrics. In general, mesh material may be formed from any suitable fabric material that exhibits acceptable acoustic performance, such as for example, sound transparency of 90% or more.

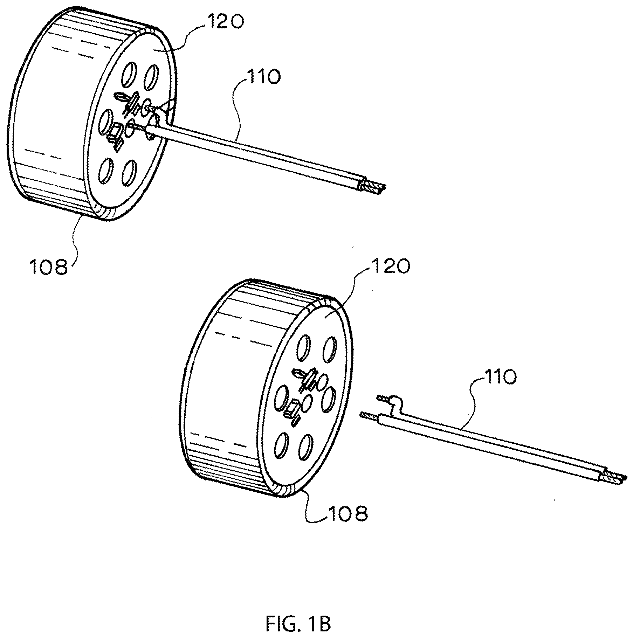

As shown in FIGS. 1A - 1B, microphone 100 may further include an electret capsule 108 connected to an audio interface 116 via a wire 110. Electret capsule 108 may include a biasing arrangement of field effect transistors to achieve low noise, as detailed below. While a wire is shown, other connection types are contemplated such as a pin connection or terminal connection. As shown in FIG. 1B, wire 110 may be soldered onto a printed circuit board 120 of the electret capsule 100.

Audio connector 116 may facilitate transmitting audio signals, such as analog or digital frequencies to, for example, a speaker. In one instance, audio connector 116 may be an XLR connector having between three and seven pins.

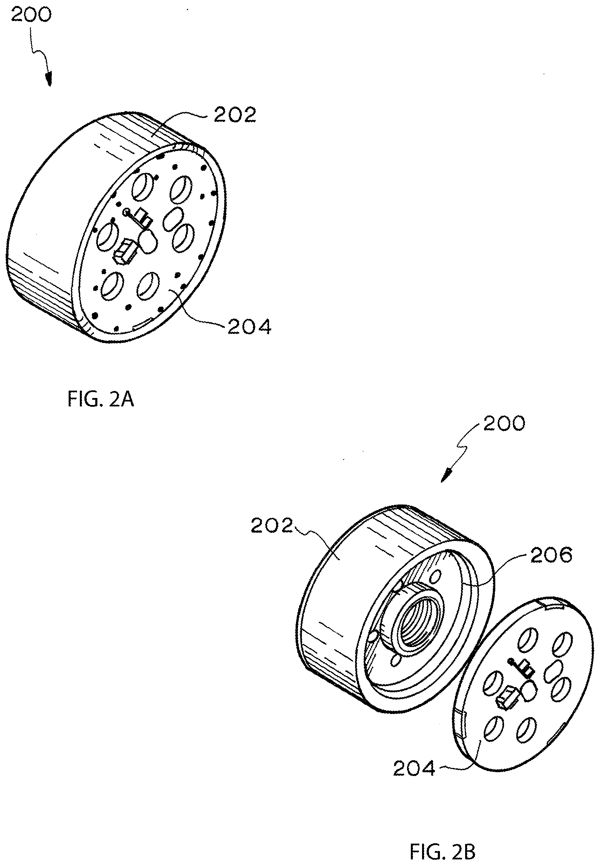

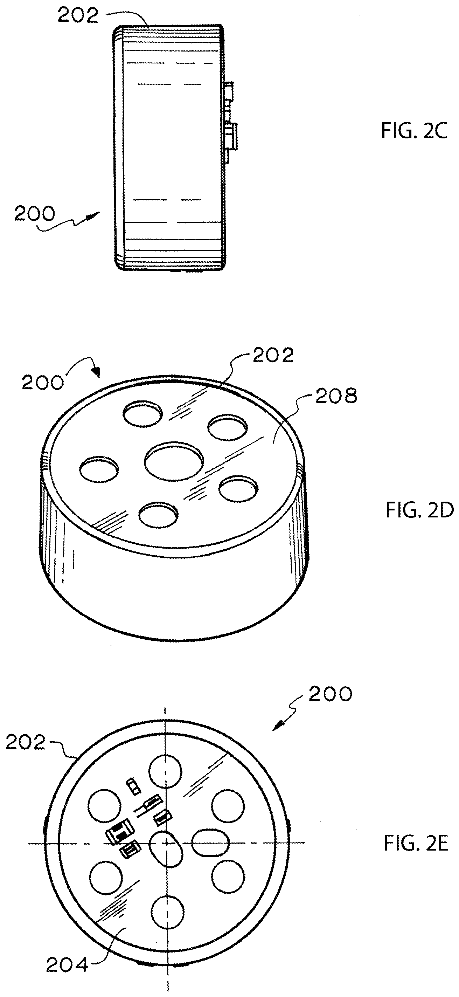

FIGS. 2A - 2E illustrate an exemplary electret capsule 200. As shown, electret capsule 200 may include a housing 202 and a printed circuit board (PCB) 204. Housing 202 may include a top surface 206 and a bottom surface 208. As shown, a PCB 204 may couple with top surface 206, such as via a contact spring as detailed below.

Although electret capsule 200 is not limited to specific dimensions, the width of housing 202 may range between about four millimeters and about eight millimeters and preferably between about five millimeters and about seven millimeters. In one embodiment, housing 202 is about six and three tenths millimeters in width. The diameter of electret capsule 200 may range between about four millimeters and about twenty millimeters and preferably between about twelve millimeters and about sixteen millimeters. In one embodiment, the diameter of electret capsule 200 is about fourteen millimeters.

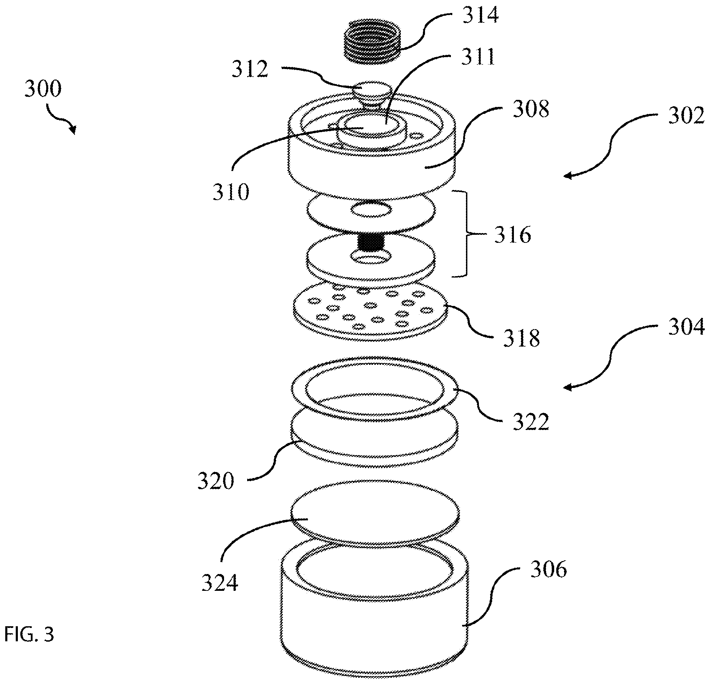

FIG. 3 illustrates an exploded view of an exemplary electret capsule 300. As shown, electret capsule 300 may include a backplate assembly 302, a diaphragm assembly 304, and a housing 306. Housing 306 may be configured to hold the components of assemblies 302, 304.

Backplate assembly 302 may include a support member 308. Support member 308 may include an opening 310 defined by one or more interior walls 311. An electrically conducting rod 312 may be slidably disposed within opening 310. A contact spring 314 is disposed about rod 312 in abutment with the interior walls of opening 310. Spring 314 may facilitate electrical contact between the rod and damping discs 316, which may be in contact with a backplate 318. Damping discs 316 may be constructed of non-conductive porous material such as non-woven fabrics or foams.

Backplate 318 may be a conductive perforated disc coated in an electret material such as polytetrafluoroethylene (PTFE), which is given a permanent polarization charge. Although not shown in FIG. 3, backplate 318 may be electrically connected to a printed circuit board (PCB) via spring 314.

Backplate 318 also may be electrically isolated from a diaphragm 320 of assembly 304 via a non-conductive gasket 322. Diaphragm 320 may be constructed of a flexible material that is configured to vibrate in response to sound waves. For example, diaphragm 320 may be a flexible film forming a vibratile diaphragm which will respond to sound waves passing through a mesh 324. Diaphragm 320 may be electrostatically polarized such that vibrations in response to sound waves result in an alternating potential being developed between the diaphragm 320 and the backplate 318. In addition, backplate 318 may include a plurality of apertures, which contribute to the level of volume between the diaphragm 320 and backplate 318.

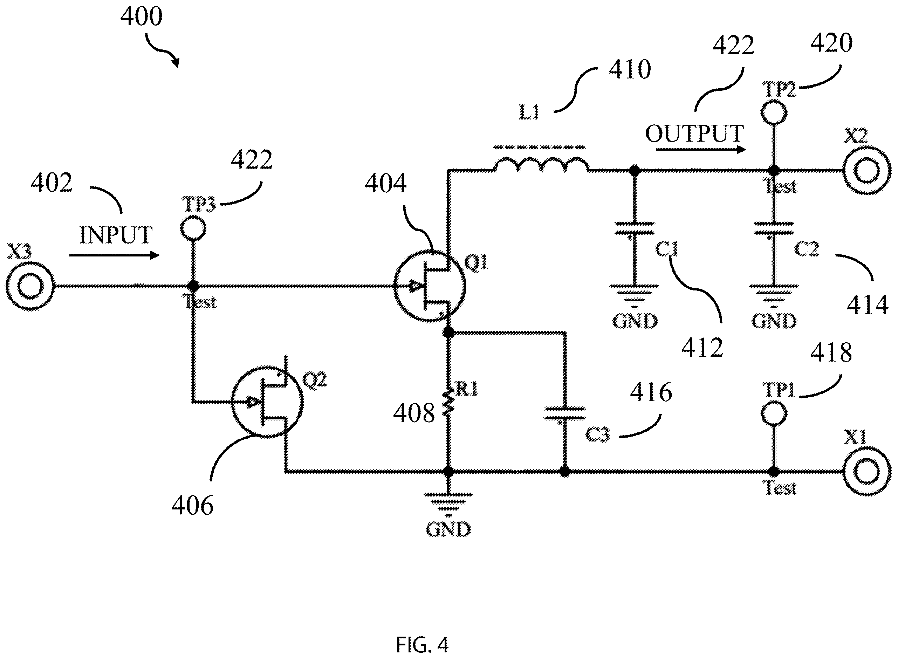

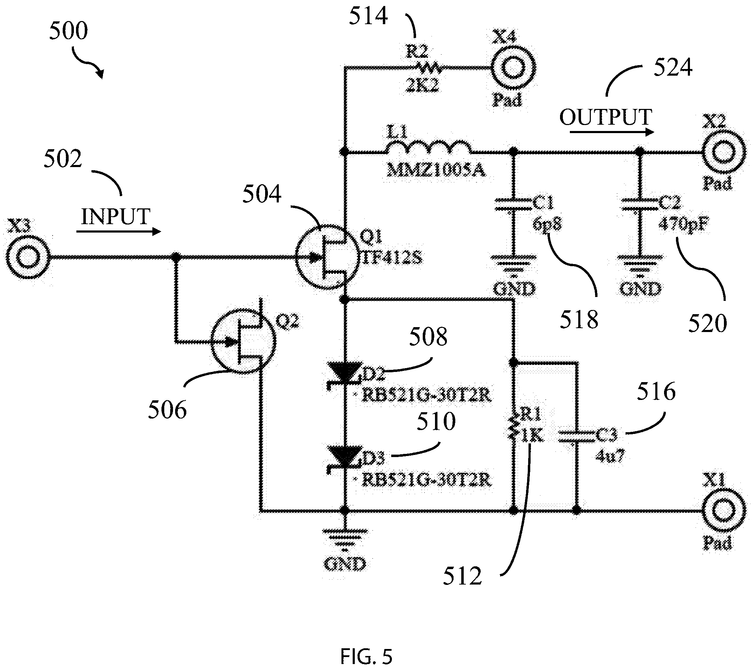

FIGS. 4 and 5 illustrates exemplary circuits 400, 500 of an electret capsule including two field-effect transistors (FETs), biasing diodes, and biasing resistors arranged within an electrical circuit. It is further contemplated that the capsule may be a kind of a capsule which needs a polarization power supply.

As illustrated in FIG. 4 and FIG. 5, an electret capsule includes a gate biasing field effect transistor (FET) to facilitate biasing of a low noise FET. Advantageously, the use of low noise FET in an electret capsule provides for a reduced cost, while achieving lower self-noise.

As illustrated in FIG. 4, exemplary circuit 400 may include two FETs or junction field effect transistor (J-FETs) 404, 406, a resistor 408, and inductor 410, three capacitors 412, 414, 416, and three test points 418, 420, 422. Each FET 404, 406 includes a source, a drain, and a gate electrode.

As shown in FIG. 4, FETs 404, 406 are arranged according to a biasing arrangement such that first FET 404 is an impedance converter low noise FET and said FET 406 is a gate biasing FET. An input 402 is provided to the gate electrodes of the first FET 404 and second FET 406. The source electrode of the first FET 404 is connected to source electrode of the second FET 406 and ground through resistor 408. Capacitor 416 is configured as a bypass capacitor in parallel with resistor 408.

The drain electrode of first FET 404 may be connected to ground by inductor 410 and one or more bypass capacitors 412, 414 in series. The arrangement of the inductor 410 and capacitors 412, 414 may facilitate improved noise rejection of the circuit with regards to an output signal 422. Since second FET 406 is used for biasing first FET 404, the drain electrode of second FET 406 is open.

As illustrated in FIG. 5, exemplary circuit 500 includes two FETs 504, 506, two voltage reference diodes (e.g., zener diodes) 508, 510, two resistors 512, 514, three capacitors 516, 518, 520, and an inductor 522. Each FET 504, 506 (which may be a J-FET) includes a source, a drain, and a gate electrode.

As shown, FETs 504, 506 are arranged according to a biasing arrangement such that first FET 504 is an impedance converter low noise FET and said FET 506 is a gate biasing FET. An input signal 502 may be provided to the gate electrodes of the first FET 504 and second FET 506.

The source electrode of the first FET 504 is connected to the source electrode of second FET 506 and ground through two zener diodes 508, 510 such that a positive bias potential is established at the source. In one embodiment, zener diodes 508, 510 may be a schottky diode.

Zener diodes 508, 510 may be connected in parallel with resistor 512 and capacitor 516. The positioning of the biasing diodes and biasing resistors within the electrical circuit may be configured to provide a combined "hybrid bias" upon the FETs 504, 506. While resistor 512 is shown to have a resistance of 1K, the value may be varied so as to compensate for variations in the characteristics of FETs 504, 506.

The drain electrode of first FET 504 may be connected to ground by inductor 522 and one or more bypass capacitors 518, 522 in series. The arrangement of the inductor 522 and capacitors 518, 520 may facilitate improved noise rejection of the circuit with regards to an output signal 524.

The drain electrode of first FET 504 may also be connected in series with resistor 514, which may be configured as a current limiting resistor. Since second FET 506 is used for biasing first FET 504, the drain electrode of second FET 506 is open.

As illustrated in FIG. 4 and FIG. 5, a gate biasing FET or J-FET may facilitate the biasing of a low noise FET or J-FET, thereby avoiding the need for cost and size prohibitive components otherwise required to achieve said biasing. Doing so enables the use of low noise J-FET in an electret capsule microphone at a reduced cost, while achieving lower self-noise.

## Claims

1. An electret capsule circuit (400;500) comprising:
a first impedance converter low noise field effect transistor FET (404;504) suitable for providing thermal stability and noise reduction, and
a second gate biasing field effect transistor FET (406;506), each of said first and second FET (404;504, 406;506) including a source, a drain, and a gate;
a resistor (408;512) having a first terminal connected to the source electrode of said first FET (404;504) and a second terminal connected to a ground terminal;
a bypass capacitor (416;516) in parallel with said resistor (408;512),
wherein said first FET (404;504) and said second FET (406;506) are configured in a biasing arrangement in which said gate electrode of said first FET (404; 504) is connected to said gate electrode of said second FET (406;506), and both of said gate electrodes are connected to a common input (402); and
wherein said second FET (406;506), being configured to biasing said first FET (404; 504), comprises an open drain configuration; and
wherein said source electrode of said first FET (404; 504) is connected to said source electrode of said second FET (406;506) and ground through said resistor (408;512).

2. Electret capsule circuit (500) according to claim 1, wherein said circuit further comprises a hybrid biasing configuration affecting said first FET (504) and said second FET (506), said configuration comprising:
- a couple of biasing diodes (508,510) for noise and signal gain reduction, said couple of diodes (508,510) being connected in series with each other and arranged in said circuit in order to connect said source electrode of said first FET (504) to said source electrode of said second FET (506) and to ground to establish a positive bias potential on said source electrodes;
- a biasing resistor (514) for thermal stability, said biasing resistor (514) arranged in said circuit having a first terminal connected in series to said drain electrode of said first FET (504).

3. Electret capsule circuit (500) according to claim 2, wherein said resistor (512) has a resistance value, preferably 1KΩ, suitable for varying in order to compensate for variations in output characteristic of said FETs (504,506).

4. Electret capsule circuit (500) according to claim 2 or 3, wherein said biasing diodes are selected from: zener diode, schottky diode.

5. Electret capsule circuit (400;500) according to claim 1 or 2, wherein said circuit further comprises an improved noise rejection configuration for an output signal (524), said configuration comprising an inductor (522) having a first terminal connected in series to said drain electrode of said first FET (404;504) and a second terminal in series with a first capacitor (412;518) and a second capacitor, wherein said first and second capacitor are disposed in parallel (418;520).

6. The electret capsule circuit according to at least one of the preceding claims, wherein said first FET (404;504) and said second FET (406;506) are junction field effect transistors (J-FETs).

7. Electret microphone capsule for electret microphone (108;200;300) comprising an electret capsule microphone circuit (400;500) according to one or more of the preceding claims.

8. Electret microphone capsule (108;200;300) according to claim 7, wherein said electret microphone capsule (108;200;300) further comprises a printed circuit board (120;204), PCB, coupling with a top surface (206) of an external housing (306) of said electret microphone capsule (108;200;300).

9. Electret microphone capsule (108;200;300) according to claim 8, wherein said printed circuit board (120;204) comprises connection means (110) to an audio interface (116).

10. Electret microphone capsule (108;200;300) according to claim 9, wherein said connection means comprise at least one selected from: PCB pin, wire lead, terminal.

## Patentansprüche

1. Eine Elektretkapselschaltung (400; 500), umfassend:
einen ersten impedanzwandelnden rauscharmen Feldeffekttransistor FET (404; 504), der zur Bereitstellung von thermischer Stabilität und Rauschreduzierung geeignet ist,
und einen zweiten Gate-vorspannenden Feldeffekttransistor FET (406; 506), wobei jeder der ersten und zweiten FETs (404; 504, 406; 506) eine Source, einen Drain und ein Gate aufweist;
einen Widerstand (408; 512) mit einem ersten Anschluss, der mit der Source-Elektrode des ersten FET (404; 504) verbunden ist, und einem zweiten Anschluss, der mit einem Masseanschluss verbunden ist;
einen Bypass-Kondensator (416; 516) parallel zu dem Widerstand (408; 512),
wobei der erste FET (404; 504) und der zweite FET (406; 506) in einer Vorspannungsanordnung konfiguriert sind, in der die Gate-Elektrode des ersten FET (404; 504) mit der Gate-Elektrode des zweiten FET (406; 506) verbunden ist und beide Gate-Elektroden mit einem gemeinsamen Eingang (402) verbunden sind; und
wobei der zweite FET (406; 506), der zur Vorspannung des ersten FET (404; 504) konfiguriert ist, eine Open-Drain-Konfiguration umfasst; und
wobei die Source-Elektrode des ersten FET (404; 504) mit der Source-Elektrode des zweiten FET (406; 506) und über den Widerstand (408; 512) mit Masse verbunden ist.

2. Elektretkapselschaltung (500) nach Anspruch 1, wobei die Schaltung ferner eine hybride Vorspannungskonfiguration umfasst, die den ersten FET (504) und den zweiten FET (506) beeinflusst, wobei die Konfiguration umfasst:
- ein Paar Vorspannungsdioden (508, 510) zur Rausch- und Signalverstärkungsreduzierung, wobei das Paar Dioden (508, 510) miteinander in Reihe geschaltet und in der Schaltung angeordnet ist, um die Source-Elektrode des ersten FET (504) mit der Source-Elektrode des zweiten FET (506) und mit Masse zu verbinden, um ein positives Vorspannungspotential an den Source-Elektroden zu erzeugen;
- einen Vorspannungswiderstand (514) für thermische Stabilität, wobei der Vorspannungswiderstand (514) in der Schaltung so angeordnet ist, dass ein erster Anschluss in Reihe mit der Drain-Elektrode des ersten FET (504) geschaltet ist.

3. Elektretkapselschaltung (500) nach Anspruch 2, wobei der Widerstand (512) einen Widerstandswert, vorzugsweise 1 kΩ, aufweist, der geeignet ist, zum Ausgleich von Schwankungen in der Ausgangscharakteristik der FETs (504, 506) variiert zu werden.

4. Elektretkapselschaltung (500) nach Anspruch 2 oder 3, wobei die Vorspannungsdioden ausgewählt sind aus: Zener-Diode, Schottky-Diode.

5. Elektretkapselschaltung (400; 500) nach Anspruch 1 oder 2, wobei die Schaltung ferner eine verbesserte Störunterdrückungskonfiguration für ein Ausgangssignal (524) umfasst, wobei die Konfiguration einen Induktor (522) umfasst, dessen erster Anschluss in Reihe mit der Drain-Elektrode des ersten FET (404; 504) und dessen zweiter Anschluss in Reihe mit einem ersten Kondensator (412; 518) und einem zweiten Kondensator geschaltet ist, wobei der erste und der zweite Kondensator parallel geschaltet sind (418; 520).

6. Die Elektretkapselschaltung nach mindestens einem der vorhergehenden Ansprüche, wobei der erste FET (404; 504) und der zweite FET (406; 506) Sperrschicht-Feldeffekttransistoren (J-FETs) sind.

7. Elektretmikrofonkapsel für ein Elektretmikrofon (108; 200; 300), umfassend eine Elektretkapselmikrofonschaltung (400; 500) nach einem der vorhergehenden Ansprüche.

8. Elektretmikrofonkapsel (108; 200; 300) nach Anspruch 7, wobei die Elektretmikrofonkapsel (108; 200; 300) ferner eine Leiterplatte (120; 204), PCB, umfasst, die mit einer Oberseite (206) eines externen Gehäuses (306) der Elektretmikrofonkapsel (108; 200; 300) gekoppelt ist.

9. Elektretmikrofonkapsel (108; 200; 300) nach Anspruch 8, wobei die Leiterplatte (120; 204) Verbindungsmittel (110) zu einer Audioschnittstelle (116) umfasst.

10. Elektretmikrofonkapsel (108; 200; 300) nach Anspruch 9, wobei die Verbindungsmittel mindestens eines ausgewählt aus: Leiterplattenstift, Drahtanschluss, Klemme umfassen.

## Revendications

1. Un circuit de capsule à électret (400; 500) comprenant :
un premier transistor à effet de champ (FET) (404; 504) convertisseur d'impédance à faible bruit, apte à fournir une stabilité thermique et une réduction du bruit, et
un second transistor à effet de champ (FET) (406; 506) de polarisation de grille, chacun desdits premier et second FET (404; 504, 406; 506) incluant une source, un drain et une grille;
une résistance (408; 512) ayant une première borne connectée à l'électrode de source dudit premier FET (404; 504) et une seconde borne connectée à une borne de masse ;
un condensateur de dérivation (416; 516) en parallèle avec ladite résistance (408; 512),
dans lequel ledit premier FET (404; 504) et ledit second FET (406; 506) sont configurés dans un agencement de polarisation dans lequel ladite électrode de grille dudit premier FET (404; 504) est connectée à ladite électrode de grille dudit second FET (406; 506), et les deux électrodes de grille sont connectées à une entrée commune (402) ;
et dans lequel ledit second FET (406; 506), étant configuré pour polariser ledit premier FET (404; 504), comprend une configuration à drain ouvert ;
et dans lequel ladite électrode de source dudit premier FET (404; 504) est connectée à ladite électrode de source dudit second FET (406; 506) et à la masse à travers ladite résistance (408; 512).

2. Circuit de capsule à électret (500) selon la revendication 1, dans lequel ledit circuit comprend en outre une configuration de polarisation hybride affectant ledit premier FET (504) et ledit second FET (506), ladite configuration comprenant :
- une paire de diodes de polarisation (508, 510) pour la réduction du bruit et du gain de signal, ladite paire de diodes (508, 510) étant connectée en série l'une avec l'autre et agencée dans ledit circuit afin de connecter ladite électrode de source dudit premier FET (504) à ladite électrode de source dudit second FET (506) et à la masse pour établir un potentiel de polarisation positif sur lesdites électrodes de source ;
- une résistance de polarisation (514) pour la stabilité thermique, ladite résistance de polarisation (514) étant agencée dans ledit circuit avec une première borne connectée en série à ladite électrode de drain dudit premier FET (504).

3. Circuit de capsule à électret (500) selon la revendication 2, dans lequel ladite résistance (512) a une valeur de résistance, de préférence 1 kΩ, apte à varier afin de compenser les variations de la caractéristique de sortie desdits FET (504, 506).

4. Circuit de capsule à électret (500) selon la revendication 2 ou 3, dans lequel lesdites diodes de polarisation sont sélectionnées parmi : une diode Zener, une diode Schottky.

5. Circuit de capsule à électret (400; 500) selon la revendication 1 ou 2, dans lequel ledit circuit comprend en outre une configuration de réjection de bruit améliorée pour un signal de sortie (524), ladite configuration comprenant une bobine (522) ayant une première borne connectée en série à ladite électrode de drain dudit premier FET (404; 504) et une seconde borne en série avec un premier condensateur (412; 518) et un second condensateur, dans lequel lesdits premier et second condensateurs sont disposés en parallèle (418; 520).

6. Le circuit de capsule à électret selon au moins l'une des revendications précédentes, dans lequel ledit premier FET (404; 504) et ledit second FET (406; 506) sont des transistors à effet de champ à jonction (J-FETs).

7. Capsule de microphone à électret pour microphone à électret (108; 200; 300) comprenant un circuit de microphone de capsule à électret (400; 500) selon l'une quelconque des revendications précédentes.

8. Capsule de microphone à électret (108; 200; 300) selon la revendication 7, dans laquelle ladite capsule de microphone à électret (108; 200; 300) comprend en outre une carte de circuit imprimé (120; 204), PCB, se couplant à une surface supérieure (206) d'un boîtier externe (306) de ladite capsule de microphone à électret (108; 200; 300).

9. Capsule de microphone à électret (108; 200; 300) selon la revendication 8, dans laquelle ladite carte de circuit imprimé (120; 204) comprend des moyens de connexion (110) à une interface audio (116).

10. Capsule de microphone à électret (108; 200; 300) selon la revendication 9, dans laquelle lesdits moyens de connexion comprennent au moins un élément sélectionné parmi : une broche de PCB, un fil conducteur, une borne.
